## Europäisches Patentamt
## European Patent Office
## Office européen des brevets

(11) Publication number: **0 130 222**
**B1**

(12) **EUROPEAN PATENT SPECIFICATION**

(45) Date of publication of patent specification: 25.05.88

(51) Int. Cl.⁴: **G 03 F 7/02**

(21) Application number: **83105936.5**

(22) Date of filing: **16.06.83**

(54) Cover film for printing plate.

(43) Date of publication of application:
**09.01.85 Bulletin 85/02**

(45) Publication of the grant of the patent:
**25.05.88 Bulletin 88/21**

(84) Designated Contracting States:
**CH DE FR GB IT LI NL**

(56) References cited:
**DE-A-2 533 156**
**FR-A-1 570 757**

**PATENTS ABSTRACTS OF JAPAN, vol. 6, no. 198(P-147)(1076), 7th October 1982**

(73) Proprietor: **TORAY INDUSTRIES, INC.**
**2, Nihonbashi-Muromachi 2-chome Chuo-ku Tokyo 103 (JP)**

(72) Inventor: **Nagase, Kimikazu**
**A2-25, 10, 2-chome Sonoyama**
**Otsu-shi, Shiga-ken (JP)**
Inventor: **Kasio, Shigetora**
**A2-81, New-Polis Fukawa Konan-cho**
**Koga-gun, Shiga-ken (JP)**
Inventor: **Fujikawa, Junichi**
**484, Yasa-Akimotocho Sakyo-ku**
**Kyoto-shi Kyoto-fu (JP)**
Inventor: **Shimokawa, Yoichi**
**15-28, 2-chome, Nakanosho**
**Otsu-shi Shiga-ken (JP)**

(74) Representative: **Kador . Klunker . Schmitt-Nilson . Hirsch**
**Corneliusstrasse 15**
**D-8000 München 5 (DE)**

**0 130 222**

**Description**

The present invention relates to a cover film for a planographic printing plate and particularly to a cover film for a printing plate superior in contact with an image-bearing film and little badly affecting the image reproducibility.

Heretofore, in order to improve the contact between a printing plate and an image-bearing film, there has been proposed and known a technique in which a mat layer is provided on the printing plate which is brought into contact with the image-bearing film, such as the methods disclosed in US—A—4,216,289 and US—A—4,288,526.

In all of these methods, a mat layer is provided directly on a photosensitive layer. On the other hand, in the case of a printing plate which requires a cover film, it is necessary to provide a mat layer on the cover film in order to improve the contact with an image-bearing film. In this connection, reference is made below to the effect of a mat layer in the presence of a cover film and also in the absence of such film.

(1) As to the contact with an image-bearing film, the mat layer is effective almost equally in both cases.

(2) As to the influence of scattering of light in the mat layer upon the image reproducibility of the printing plate, there is a great difference between both cases. More particularly, in the absence of a cover film, scattering of light in the mat layer will little badly affect the image reproducibility because the photosensitive layer is adacent to the mat layer. On the other hand, in the presence of a cover film, scattering of light in the mat layer will cause a bad influence on the image reproducibility because the scattered light passes through the cover film before reaching the photosensitive layer.

Thus, the effect of a mat layer differs between the case where a cover film is present and the case where it is omitted. Therefore, in case the technique of providing a mat layer directly on a photosensitive layer is applied as it is to a printing plate which requires a cover film, it is difficult to attain both a superior contact with an image-bearing film and a superior image reproducibility at a time.

Reference is here made to Japanese Patent Laid Open Publication No. 55343/80 which shows a technique for improving the contact with an image-bearing film by providing a mat layer on the surface of a cover film. This technique involves the following two methods according to a broad classification:

1) Method in which the film surface is matted by processing.

2) Method in which the film surface is matted by the provision of a coating layer which contains inorganic particles.

In the above method 1), all of the embodiments described in the Japanese Patent Laid Open Publication in question are difficult to attain both a superior contact and a superior image reproducibility at a time. Since this method requires processing of the film itself, it involves associated problems, for example, an increase in scale of the manufacturing equipment is required, and thus the above method 1) is not suitable for a small volume production. In the above method 2), surface unevenness is formed by the inorganic particles. In this case, since the inorganic particles are generally spherical, scattering of light by the surface unevenness is increased, which is liable to deteriorate the image reproducibility. Therefore, with the provision of a coating layer containing inorganic particles on the cover film surface, it is difficult to attain both a superior contact with an image-bearing film and a superior image reproducibility at a time.

DE—A—25 33 156 discloses a process for preparing a light-sensitive printing plate consisting of a support at a light-sensitive layer thereon. Thereby the upper layer of the light-sensitive printing plate is applied using a roller with uneven or irregular surface. Onto this photo-sensitive layer a transparent matting layer is directly applied.

It is an object of the present invention to provide a cover film for a planographic printing plate superior in contact with an image-bearing film and little badly affecting the image reproducibility.

It is another object of the present invention to provide a printing plate superior in contact with an image-bearing film and also supperior in image reproducibility.

It is a further object of the present invention to provide a method of producing a cover film for a planographic printing plate superior in contact with an image-bearing film and little badly affecting the image reproducibility.

Other and further objects and effects of the present invention will become apparent from the following detailed description.

According to the present invention, there is provided a dry planographic printing plate defined by the features of the claims.

The cover film of the present invention is superior in contact with an image-bearing film and diminishes scattering of light induced by surface unevenness. Consequently, in a printing plate of the type which is exposed to light without removing a cover film, for example, in a dry planographic printing plate having an ink-repellent portion formed by a silicone rubber layer, it is possible to attain both a superior contact with an image-bearing film and a superior image reproducibility at a time.

Fig. 1 is a sectional view of the cover film of the present invention; and

Figs. 2 and 3 are plan views (a) and sectional views (b) of cells of gravure rolls used in the production of the cover film of the present invention.

In a printing plate which must be covered with a cover film until just before development because the plate surface is easily scratched or for some other reason, for example, in a dry planographic printing plate having an ink-repellent portion formed by a silicone rubber layer, such as those disclosed in

2

# 0 130 222

US—A—3,894,873, US—A—4,342,820, US—A—4,347,303 and US—A—4,358,522, the cover film exists between an image-bearing film and a photosensitive layer at the time of exposure. As a result, the light scattered between the image-bearing film and the cover film is diffused while passing through the cover film, and for this reason the reproduction of very small dots of the image-bearing film tends to be difficult as compared with a printing plate not requiring a cover film.

Consideration will now be given about the scattering of light occurring between an image-bearing film and a cover film. The smoother the cover film surface, the smaller the amount of light scattered and the easier the reproduction of very small dots. On the other hand, as to the vacuum contact between an image-bearing film and a cover film, the higher the degree of matting of the cover film surface, the better the vacuum contact. Thus, the degree of matting of the cover film surface should be decided while considering both image reproducibility and vacuum contact. But, it has been difficult for the conventional techniques to attain both a satisfactory image reproducibility and a satisfactory vacuum contact at a time.

It has now been found that a superior reproducibility is attainable while retaining a good vacuum contact by using a cover film which has a specific shape of convex projections formed on its surface. More particularly, it has now been found that the contact with an image-bearing film is improved and a bad influence upon image reproducibility is minimized by using a cover film which comprises a light-transmissible smooth base film and a light-transmissible resinous coating layer formed on one side of the base film, the resinous coating layer having 50 to 10,000, preferably 100 to 2,000, convex projections per square centimeter, with a half-value width [b] of each such convex projection being 5 to 300, preferably 10 to 150, times the height [a] of the vertex of the convex projection which height [a] is in the range of 1 to 10 µm, preferably 2 to 5 µm.

It is preferable that the area of the coating layer portion having a thickness not larger than one fifth of the height [a] of the vertex of the convex projection be in the range of 10 to 90% of the surface area of the base film, and that an inter-vertex distance [c] between adjacent convex projections be in the range of 100 to 1,500 µm.

Values outside the ranges defined above would result in impairement of either the image reproducibility or the contact with an image-bearing film.

The "light-transmissible" as referred to herein means a light transmissibility not less than 50% for an actinic light (wavelength: 300—500 nm), for example.

The "smooth" as referred to herein means a smoothness having a value of Ra not larger than 0.4 µm, wherein Ra represents the center line average roughness as defined in paragraph 5 of page 4 of JIS B-0601.

The "vertex of the convex projection" as referred to herein indicates the point of maximum thickness of the coating layer.

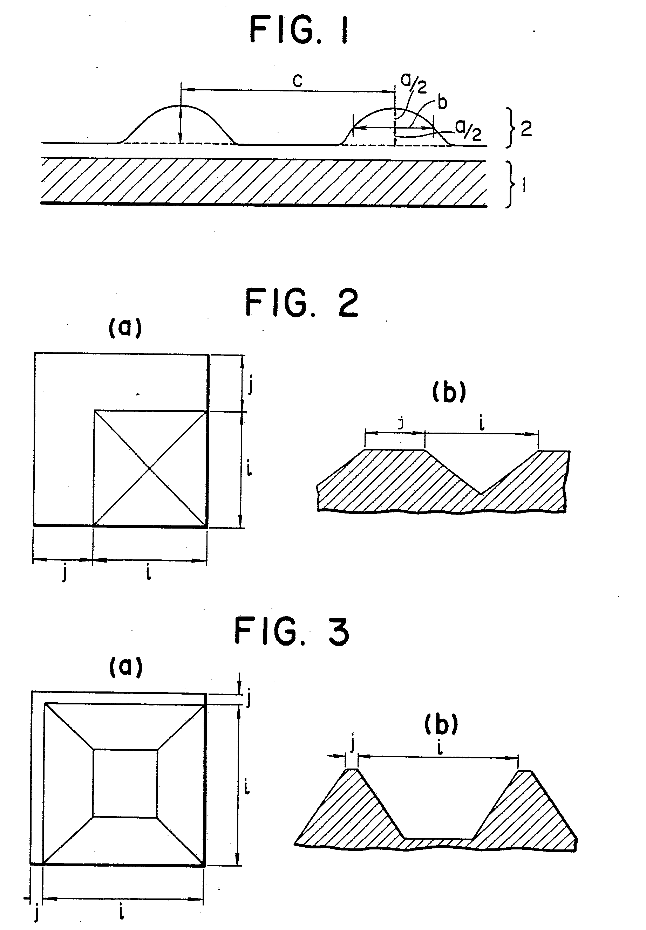

The "height [a] of the vertex of the convex projection" as referred to herein indicates a height obtained by subtracting the minimum thickness from the maximum thickness of the coating layer 2 on the base film 1, as shown in Fig. 1.

The "half-value width [b] of the convex projection" as referred to herein indicates the width of the convex projection at a half point of the height [a] of the vertex of the convex projection, as shown in Fig. 1.

The base film used in the present invention is not specially limited provided it is light-transmittable as previously defined. Examples of such base film include plastic films such as those formed of polyethylene, polypropylene, polyester, polyamide, polyvinylidene chloride, polystyrene, polyvinyl chloride, polybutadiene and polyvinyl alcohol, as well as composite films consisting of two or more of the plastic films just exemplified. It is also preferable that these films be subjected in advance to a surface treatment such as a corona discharge treatment or the like and/or a metal deposition treatment in a range not impairing the light transmissibility of the film.

As the material of the base film, it is desirable from the standpoint of its strength and versatility that a polyolefin such as polyethylene or polypropylene, a polyester and/or a polyamide be contained in a proportion not less than 90%. Particularly preferred is a polyester film.

The base film has a thickness preferably in the range of 1 to 20 µm. Its thickness larger than 20 µm is likely to deteriorate the image reproducibility, and its thickness smaller than 1 µm causes problems associated with the strength, etc. of the base film itself.

Using the dry planographic printing plate of the present invention, defined by the main claim, it is preferable that the oxygen permeability of the base film be not more than 2,000 cc/m² · 24 hr · bar/sheet. As examples of the printing plate described above, mention may be made of the dry planographic printing plates disclosed in US—A—3,894,873, US—A—4,342,820, US—A—4,347,303 and US—A—4,358,522.

The material of the resinous coating layer used in the present invention is not specially limited provided it is light-transmissible as previously defined and can retain its shape at normal temperatures (−20°C to 60°C). Examples of such resin include polyolefin resins, chlorinated polyolefin resins, polyester resins, butyral resins, vinylidene chloride resins, vinyl chloride resins, alkyd resins, acrylic resins, epoxy resins, polyamide resins, polyurethane resins, polyvinyl alcohol resins, phenolic resins, and natural resins. These resins may be used alone or in combination of two or more.

Further, since the resinous coating layer is formed by means of coating, it is desirable to use a thermoplastic resin as the resin of the coating layer from the standpoint of stability of the coating solution and easiness of its application. Preferred examples of such thermoplastic resin are polyester resins and butyral resins.

3

0 130 222

The method of preparing the resinous coating layer is not specially limited, but preferably a solution of a resin or a precursor thereof having a viscosity in the range of 0.05 to 3.0 Pas is applied onto the surface of the base film by means of a gravure roll having an area of cell portion in the range of 10 to 80% of the surface area of the gravure roll, and then the coating is hardened to form a coating layer having convex projections.

The shape of the cells of the gravure roll is not specially limited, for example, the cells may be in the form of a geometrical pattern such as a lattice, oblique lines, pyramids or the like, or even a pattern not having a specific regularity, provided the area of cell portion of the roll is in the range of 10 to 80%, preferably 10 to 60%, of the roll surface area.

If the area of cell portion exceeds 80% of the roll surface area, the concaves and convexes formed on the film will assume a shape with overlapped projections, so it is impossible to obtain a film having the desired concaves and convexes.

If the area of cell portion is below 10% of the roll surface area, it is difficult to obtain a convex projection of a relatively large height, and a film having the desired concaves and convexes is not obtained. It is necessary that the cells of the gravure roll be disposed substantially uniformly on the roll surface.

The cell as referred to herein is as shown, for example, in Figs. 2 and 3 in each of which (a) is a plan view and (b) is a sectional view, both illustrated schematically. The area of cell portion as referred to herein indicates the area of the opening portion of the cell, namely, $i \times i$. The ratio of the area of cell portion to the surface area of the gravure roll is equal to

$$(i \times i) \div \{(i+j) \times (i+j)\}$$

in the case where cells of such a shape as shown in Fig. 2 or Fig. 3 are existent uniformly on the roll surface.

The coating solution used herein should have a viscosity in the range of 0.05 to 3.0 Pas, preferably 0.1 to 1.5 Pas, when applied to the base film. If its viscosity is below 0.05 Pas, the concaves and convexes formed just after coating will immediately be levelled and not be recognized after drying. If its viscosity exceeds 3.0 Pas, application per se of the coating solution will be difficult, so it is impossible to obtain a film having stable characteristics. Further, the coating solution used herein should form the foregoing coating layer after drying or curing.

The solvent of the coating solution is not specially limited. For example, there may be used petroleum solvents; aromatic hydrocarbons, e.g. toluene; ketones, e.g. methyl ethyl ketone; alcohols, e.g. ethanol; ethers, e.g. tetrahydrofuran; and inorganic polar solvents, e.g. water. These solvents may be used alone or in combination of two or more.

For imparting thixotropy to the coating solution and for improving the slipperiness of the uneven surface layer, there may be added a small amount of an inorganic substance such as silicon dioxide, titanium dioxide or calcium carbonate, or an organic substance incompatible with the coating resin. Further, in order to improve the dispersion stability of such inorganic or organic substance and to impart an antistatic property, there may be added a surface active agent.

The coating solution thus prepared is applied onto the film surface by means of the foregoing gravure and then cured to obtain a light-transmissible film having concaves and convexes on the surface thereof. The curing of the coating solution is performed by a conventional method such as drying, crosslinking, or the like.

The contour of such a convex projection as shown in Fig. 1 may be measured by the following methods:

1) Method which utilizes a photomicrograph of a sectional portion of the cover film.

2) Method which utilizes a tracer meter (JIS B-0651).

In the case of adopting the above method 2), it is necessary that the load applied to the stylus tip of the tracer meter be kept low.

The value of the oxygen permeability as referred to herein is a value determined by a measuring method using gas chromatography at 20°C, 0% RH and under a pressure of 1.47 bar.

The following working and comparative examples are given to further illustrate the present invention.

Example 1

A coating solution of the following composition was applied to a polypropylene film (8 µm thick) by means of a gravure roll having such a fine pattern as shown in Fig. 2 (pyramid type, i/j=2, 55 lines/2.54 cm, the area of cell portion being 44% of the roll surface area), and then dried. The viscosity of the coating solution was 0.25 Pas and its drying was performed with hot-air at 70°C for 40 seconds.

|  |  |  |
|---|---|---|
| (a) | Chlorinated polypropylene ("Superchlon 803H" a product of Sanyo-Kokusaku Pulp Co.) | 20.0 wt.% |
| (b) | Silicon dioxide (average particle size: 3 µm) | 0.6 wt.% |
| (c) | Toluene | 55.4 wt.% |
| (d) | Methyl ethyl ketone | 24.0 wt.% |

4

The film thus obtained proved to have the following characteristic values:

1) Height of convex projection, a=8~10 μm
2) Half-value width of convex projection, b=180~220 μm
3) b/a=18~28
4) Number of convex projections: 470 pcs./cm² ~ 500 pcs./cm²
5) Distance between adjacent convex projections, c=460 μm
6) Area of the coating layer portion having a thickness not larger than one fifth of the height (a) of the vertex of convex projection: 40~60% of the surface area of the base film.

Using this film, there was produced a dry planographic printing plate of a structure as will be discribed hereinafter.

A solution having the following composition (a 10% solution in ethyl cellosolve) was applied onto an aluminum base substrate and dried in hot air at 80°C to form a photopolymerizable layer having a thickness of 4 μm:

| | |
|---|---|
| (a) Polyurethane resin "Impranil ELN" (a product of Bayer) | 56 parts by weight |
| (b) Adduct of 4 moles glycidyl methacrylate and 1 mole xylylenediamine | 40 parts by weight |
| (c) Michler's ketone | 4 parts by weight |
| (d) Crystal Violet | 0.4 part by weight |

Then, a 10% diluted solution in n-hexane of a silicone having the following composition was applied onto the photopolymerizable layer and dried in hot air at 50°C to form a silicone rubber layer having a thickness of 3 μm:

| | |
|---|---|
| (a) Polydimethylsiloxane (molecular weight: about 40,000) | 100 parts by weight |
| (b) Methyltriacetoxysilane | 5 parts by weight |
| (c) Dibutyltin acetate | 0.2 part by weight |

Onto the surface of the thus-formed silicone rubber layer was laminated the previously-formed film so that the smooth side of the film (the side not having the concaves and convexes) was in contact with the silicone rubber layer.

Thus, using a vacuum printing frame, a positive film was brought into close contact with the printing plate having the above-described structure. One minute was required for attaining a close contact. As to the image reproducibility of this printing plate, 2~98% of 200 I/2.54 cm dots was reproduced.

Comparative Example 1

A coating solution of the following composition was applied to a polypropylene film (8 μm thick) by means of a gravure roll having such a fine pattern as shown in Fig. 3 (lattice type, i/j=19, 180 lines/2.54 cm, the area of cell portion being 90% of the roll surface area), and then dried. The viscosity of the coating solution was 0.05 Pas and its drying was performed with hot-air at 70°C for 40 seconds.

| | |
|---|---|
| (a) Chlorinated polypropylene ("Superchlon 803H", a product of Sanyo-Kokusaku Pulp Co.) | 15.0 wt.% |
| (b) Silicon dioxide (average particle size: 5 μm) | 1.2 wt.% |
| (c) Toluene | 58.3 wt.% |
| (d) Methyl ethyl ketone | 25.5 wt.% |

The film thus obtained proved to have the following characteristic values:

1) Height of convex projection, a=5~6 μm
2) Half-value width of convex projection, b=10~20
3) b/a=2~4
4) Number of convex projections: $1 \times 10^5$ pcs./cm²
5) Distance between adjacent convex projections, c=0~50 μm
6) There was no coating layer portion having a thickness not larger than one fifth of the height [a] of the vertex of convex projection.

Using this film, there was produced a dry planographic printing plate in the same way as in Example 1. Then, using a vacuum printing frame, a positive film was brought into close contact with the printing plate. One minute was required for attaining a close contact. As to the image reproducibility of this printing plate, however, only 5~95% of 200 I/2.54 cm dots was reproduced.

**0 130 222**

Example 2 and Comparative Example 2

Coating solutions having the compositions shown in Table 1 were each applied to a polyester film (6 μm thick) by using the similar gravure roll to that used in Example 1 (pyramid type, i/j=1, 55 lines/2,54 cm, the area of cell portion being 25% of the roll surface area), and then dried with hot-air at 70°C for 40 seconds.

TABLE 1

|  | Concentration of saturated poly-ester resin* (wt.%) | Toluene (wt.%) | Methyl ethyl ketone (wt.%) | Viscosity of coating solu-tion (Pas) |
|---|---|---|---|---|
| No. 1 | 40 | 48 | 12 | 0.5 |
| No. 2 | 25 | 60 | 15 | 0.07 |
| No. 3 | 15 | 68 | 17 | 0.02 |

* "Vylon 200" (a product of Toyobo Co.)

Table 2 below shows characteristics values of the films thus obtained.

TABLE 2

|  | Height of convex projection (μm) a | Half-value width (μm) b | b/a | Area of portion with thickness not larger than 1/5 of a (%) |
|---|---|---|---|---|
| No. 1 | 10~12 | 150~180 | 12~18 | 60~80 |
| No. 2 | 4~5 | 170~200 | 34~50 | 50~70 |
| No. 3 | 0.4~0.5 | 200~220 | 400~550 | 10~20 |

The number of convex projections was 470 pcs./cm²~500 pcs./cm², and the distance between adjacent convex projections, c=460 μm.

Using these films, there were produced dry planographic printing plate in the same way as in Example 1. Table 3 shows performances of the printing plates obtained.

TABLE 3

| Film | Time required for close contact with positive film (min.) | Image reproducibility (%) |
|---|---|---|
| No. 1 | 0.2 | 5~95 |
| No. 2 | 1.0 | 2~98 |
| No. 3 | 6.0 | 2~98 |

From Table 3 it is seen that the printing plate using film No. 1 is unsatisfactory in point of image reproducibility and the printing plate using film No. 3 unsatisfactory in point of contact with positive film.

**Claims**

1. A dry planographic printing plate comprising a base substrate, a photosensitive layer overlying said base substrate, a silicone rubber layer overlying said photosensitive layer and a cover film overlying said silicone rubber layer, said photosensitive layer containing a photoradical-polymerizable monomer or oligomer, said cover film comprising a light-transmissible smooth base film having an oxygen permeability

6

not more than 2000 cc/m² . 24 hr . bar/sheet and a thickness in the range of 1 to 20 µm, and a light-transmissible resinous coating layer formed on one side of said base film, said resinous coating layer having 50 to 10,000 convex projections per square centimeter, with a half-value width [b] of each said convex projection being in the range of 5 to 300 times the height [a] of the vertex of said convex projection which height [a] is in the range of 1 to 10 µm and an intervertex distance [c] between adjacent said convex projections in the range of 100 to 1,500 µm, and wherein the area of the coating layer portion having a thickness not larger than one fifth of the height [a] of the vertex of said projection is in the range of 10 to 90% of the surface area of said base film, said cover film being laminated onto said silicone rubber layer so that the opposite side of said base film contacts the upper surface of said silicone rubber layer.

2. The dry planographic printing plate as defined in claim 1 wherein the half-value width [b] of each said convex projection is in the range of 10 to 150 times the height [a] of the vertex of said convex projection.

3. The dry planographic printing plate as defined in claim 1 wherein the height [a] of the vertex of each said convex projection is in the range of 2 to 5 µm.

4. The dry planographic printing plate as defined in claim 1 wherein said resinous coating layer having said convex projections has been formed by applying a solution of a resin or a precursor thereof onto the surface of said base film by means of a gravure roll and then curing the thus-applied solution, said solution having a viscosity in the range of 0.05 to 3.0 Pas, and said gravure roll having an area of cell portion in the range of 10 to 80% of the surface area of the grauvre roll.

**Patentansprüche**

1. Flachdruck-Trockenplatte, die ein Grundsubstrat, eine dieses Grundsubstrat überdeckende photoempfindliche Schicht, eine die photoempfindliche Schicht überdeckende Silicongummischicht und einen die Silicongummischicht überdeckenden Abdeckfilm umfaßt, wobei die photoempfindliche Schicht ein photoradikal-polymerisierbares Monomer oder Oligomer enthält, der Abdeckfilm einen lichtdurchlässigen glatten Grundfilm, der eine Säurestoffpermeabilität von nicht mehr als 2000 cm³×24 h×bar/Lage und eine Dicke im Bereich von 1 bis 20 µm aufweist, und eine auf einer Seite dieses Grundfilms ausgebildete, lichtdurchlässige, harzartige Überzugsschicht umfaßt, wobei die harzartige Überzugsschicht pro cm² 50 bis 10 000 konvexe Vorsprünge aufweist, wobei die Halbwertbreite in [b] jedes konvexen Vorsprungs im Bereich des 5- bis 300-fachen der Höhe [a] des Scheitelpunktes des konvexen Vorsprungs liegt, wobei die Höhe [a] im Bereich von 1 bis 10 µm liegt und der Zwischenabstand [c] der Scheitelpunkte zwischen benachbarten konvexen Vorsprüngen im Bereich von 100 bis 1500 µm liegt und worin die Fläche des Abschnitts der Überzugsschicht mit einer Dicke von nicht größer als 1/5 der Höhe [a] des Scheitelpunktes des Vorsprungs im Bereich von 10 bis 90% des Oberflächenbereichs des Grundfilms liegt, wobei der Abdeckfilm auf die Silicongummischicht laminiert ist, so daß die entgegengesetzte Seite des Grundfilms die obere Oberfläche der Silicongummischicht berührt.

2. Flachdruck-Trockenplatte nach Anspruch 1, worin die Halbwertsbreite [b] jedes konvexen Vorsprungs im Bereich des 10- bis 150-fachen der Höhe [a] des Scheitelpunkts des konvexen Vorsprungs liegt.

3. Flachdruck-Trockenplatte nach Anspruch 1, worin die Höhe [a] des Scheitelpunkts jedes konvexen Vorsprungs im Bereich von 2 bis 5 µm liegt.

4. Flachdruck-Trockenplatte nach Anspruch 1, worin die harzartige Überzugsschicht, die die konvexen Vorsprünge aufweist, durch Auftragen einer Lösung eines Harzes oder einer Vorstufe davon auf die Oberfläche des Grundfilms mittels einer Tiefdruck- bzw. Gravürewalze und anschließendes Härten der so aufgebrachten Lösung gebildet wird, wobei die Lösung eine Viskosität im Bereich von 0,05 bis 3,0 Pas aufweist und die Gravürewalze eine Fläche des Farbnäpfchen- bzw. Zellenanteils im Bereich von 10 bis 80% des Oberflächenbereichs der Gravürewalze aufweist.

**Revendications**

1. Plaque d'impression planographique à sec comprenant un substrat de base, une couche photosensible recouvrant le substrat de base, une couche de caoutchouc de silicone recouvrant la couche photosensible et une pellicule de couverture recouvrant la couche de caoutchouc de silicone, la couche photosensible contenant un monomère ou un oligomère polymérisable par photoradical, la pellicule de couverture comprenant une pellicule de base lisse transmettant la lumière ayant une preméabilité à l'oxygène ne dépassant pas 2000 cc/m² . 24 h . bar/feuille et une épaisseur comprise entre 1 à 20 µm, et une couche de revêtement résineuse transmettant la lumière formée sur un côté de la pellicule de base, la couche de revêtement résineuse ayant 50 à 10 000 saillies convexes par centimètre carré, avec une largeur (b) à la mi-valeur de chaque saillie convexe comprise dans la plage égale à 5—300 fois la hauteur (a) du sommet de la saillie convexe, hauteur (a) qui est comprise dans la plage 1—10 µm et une distance inter-sommets (c) entre saillies convexes contiguës dans le plage 100—1500 µm, et où la surface de la partie de la couche de revêtement ayant une épaisseur ne dépassant pas le cinquième de la hauteur (a) du sommet de la saillie est dans la plage 10—90% de la surface de la pellicule de base, la pellicule de

7

couverture étant laminée sur la couche de caoutchouc de silicone de façon que le côté opposé de la pellicule de base soit en contact avec la surface supérieure de la couche de caoutchouc de silicone.

2. Plaque d'impression planographique à sec selon la revendication 1, dans laquelle la largeur (b) à la mi-valeur de chaque saillie convexe se trouve dans la plage égale à 10—150 fois la hauteur (a) du sommet de la saillie convexe.

3. Plaque d'impression planographique à sec selon la revendication 1, dans laquelle la hauteur (a) du sommet de chaque saillie convexe est dans la plage 2—5 µm.

4. Plaque d'impression planographique à sec selon la revendication 1, dans laquelle la couche de revêtement résineuse ayant les saillies convexes est formée par application d'une solution d'une résine ou d'un précurseur de celle-ci à la surface de la pellicule de base au moyen d'un rouleau de gravure, puis par durcissement de la solution ainsi appliquée, la solution ayant une viscosité comprise dans la gamme 0,05—3,0 Pas, et le rouleau de gravures ayant une surface de la partie cellulaire comprise entre 10 et 80% de la surface du rouleau de gravure.

0 130 222

# FIG. 1

# FIG. 2

(a)

(b)

# FIG. 3

(a)

(b)